# DEMANDE DE BREVET EUROPEEN

(11) **EP 4 187 612 A1**
(43) Date de publication de la demande: **31.05.2023**
(21) Numéro de dépôt: 22209728.9
(22) Date de dépôt: 25.11.2022
(51) Int. Cl.: H01L 29/06, H01L 29/423, H01L 29/66, H01L 29/775, H01L 21/336, B82Y 10/00, G06N 10/40

(54) **FABRICATION D'UN DISPOSITIF QUANTIQUE AVEC AUTO-ALIGNEMENT DES GRILLES SUR LEUR REGION DE ZONE ACTIVE RESPECTIVE**

(30) Priorité: 29.11.2021 FR 2112630
(71) Demandeur: Commissariat à l'énergie atomique et aux énergies alternatives, 75015 Paris (FR)
(72) Inventeur: NIEBOJEWSKI, Heimanu, 38054 GRENOBLE CEDEX 09 (FR); BERTRAND, Benoît, 38054 GRENOBLE CEDEX 09 (FR)
(74) Mandataire: Brevalex

(57) **Abrégé**

Procédé de fabrication d'un dispositif quantique, comportant, dans cet ordre, des étapes consistant à :
a) former sur une zone semi-conductrice dite « zone active » reposant sur un substrat : un empilement comprenant au moins une couche de matériau de grille et une ou plusieurs couches de masquage sur cette couche de matériau de grille,
b) former, en regard de la zone active : une tranchée de séparation par gravure à travers lesdites une ou plusieurs couches de masquage, ladite tranchée ayant un fond dévoilant ladite au moins une couche de matériau de grille,
c) former dans lesdites une ou plusieurs couches de masquage dudit empilement : une ou plusieurs paires de blocs de masquage, chaque paire de bloc de masquage comportant un premier bloc de masquage et un deuxième bloc de masquage en regard du premier bloc de masquage, le premier bloc de masquage et le deuxième bloc de masquage étant disposés en regard l'un de l'autre et de part et d'autre de ladite tranchée,
d) former, dans le prolongement de chaque bloc de masquage et par gravure de ladite au moins une couche de matériau de grille : un bloc de grille, de sorte à former une ou plusieurs paires de blocs (64, 65) de grille.

## Description

### DOMAINE TECHNIQUE

La présente demande concerne le domaine des dispositifs électroniques quantiques et en particulier celui de la fabrication d'un dispositif quantique à bits quantiques (également appelés « quantum bits » ou « Qubits ») formés d'ilots semi-conducteurs et utilisant une ou plusieurs paires d'électrodes de grille situées au-dessus des ilots.

Elle concerne plus particulièrement un procédé amélioré de réalisation d'un dispositif quantique permettant notamment d'obtenir un auto-alignement des électrodes de grille par rapport aux ilots.

### ÉTAT DE LA TECHNIQUE ANTÉRIEURE

Les îlots quantiques (parfois également appelées boîtes ou points quantiques) forment des éléments de base d'un dispositif électronique quantique. Les îlots quantiques sont typiquement formés dans une couche de matériau semi-conducteur dans laquelle des puits de potentiel sont mis en oeuvre pour confiner des porteurs, électrons ou trous, dans les trois dimensions de l'espace. Une information quantique peut être alors codée par le biais du spin du porteur. On parle alors de Qubits de spin.

Selon une approche, des électrons sont confinés par effet de champ sous l'effet d'électrodes de grilles semblables à celles utilisées dans des structures de transistors et l'information est encodée dans le spin de ces électrons. Ces grilles dites « avant » sont disposées au-dessus de l'ensemble des ilots quantiques.

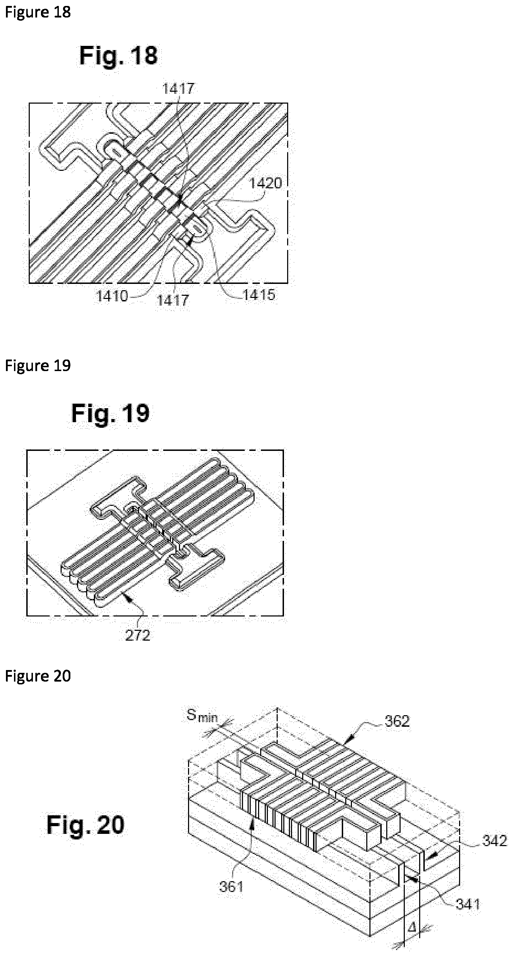

Parmi les différents types de structures de dispositif quantiques existantes, une structure connue et illustrée sur la figure 20 comporte : un premier barreau (couramment appelé « fin » selon la terminologie anglo-saxonne) semi-conducteur 341 et un deuxième barreau semi-conducteur 342 juxtaposés et des paires de grilles 364, 365 de contrôle avant, chaque paire étant formée respectivement d'une première grille 364 de contrôle avant recouvrant une portion du premier barreau 341 semi-conducteur et d'une deuxième grille de contrôle avant recouvrant une portion du deuxième barreau 342 semi-conducteur. On met ainsi en oeuvre deux parties de zone active en parallèle, la première constituée par le premier barreau 341 étant destinée à former des boites quantiques et la seconde partie constituée par le deuxième barreau 342 étant destinée à former des détecteurs de charge.

Le détecteur de charge en regard de chaque boite quantique permet de mesurer le nombre de charges piégées dans cette boite quantique. Le principe de détection repose sur un couplage capacitif entre la boite quantique et le détecteur de charges en regard de cette boite. On cherche de préférence à maximiser ce couplage capacitif afin d'améliorer l'efficacité du détecteur ce qui implique de réduire autant que possible la distance entre détecteur et boite quantique, correspondant ici à la distance Δ entre les barreaux 341, 342.

Un bon alignement des grilles sur des espaces aussi restreints est difficile à obtenir. Par ailleurs, un éventuel enroulement des grilles autour des barreaux 341, 342 peut conduire à un fort effet d'écrantage.

En outre, avec un tel agencement, une distance Δ entre les barreaux 341, 342 est plus importante que l'espace minimal Smin réalisable entre des grilles 361, 362 afin d'assurer le bon recouvrement des barreaux par les grilles. Cela limite les performances en termes de couplage électrostatique entre barreaux 341, 342.

Il se pose le problème de trouver un nouveau procédé de fabrication de dispositif quantique

### EXPOSÉ DE L'INVENTION

Selon un aspect, la présente invention concerne un procédé de fabrication d'un dispositif quantique comportant, dans cet ordre, des étapes consistant à :
a) former sur une zone semi-conductrice dite « zone active » reposant sur un substrat: un empilement comprenant au moins une couche de matériau de grille et une ou plusieurs couches de masquage sur cette couche de matériau de grille,
b) former, en regard de la zone active: une tranchée de séparation par gravure à travers lesdites une ou plusieurs couches de masquage, ladite tranchée ayant un fond dévoilant ladite au moins une couche de matériau de grille,
c) former dans lesdites une ou plusieurs couches de masquage dudit empilement : une ou plusieurs paires de blocs de masquage, chaque paire de bloc de masquage comportant un premier bloc de masquage et un deuxième bloc de masquage en regard du premier bloc de masquage, le premier bloc de masquage et le deuxième bloc de masquage étant disposés en regard l'un de l'autre et de part et d'autre de ladite tranchée,
d) former, dans le prolongement de chaque bloc de masquage et par gravure de ladite au moins une couche de matériau de grille : un bloc de grille, de sorte à former une ou plusieurs paires de blocs de grille.

Ainsi, dans le procédé défini ci-dessus plutôt que de former un ensemble de motifs de grilles que l'on vient ensuite couper et séparer en paires de blocs de grille situées en regard l'une de l'autre, on forme, au moyen de la tranchée préalablement effectuée, directement des paires de blocs de grille dont le positionnement est précis par rapport à la zone active.

Selon un autre aspect, la présente invention concerne un procédé de fabrication d'un dispositif quantique comprenant des étapes de :
- formation sur une zone semi-conductrice dite « zone active » reposant sur un substrat: d'un empilement comprenant au moins une couche de matériau de grille et une ou plusieurs couches de masquage sur cette couche de matériau de grille, puis
- formation, en regard de la zone active : d'une tranchée de séparation par gravure à travers lesdites une ou plusieurs couches de masquage,
- retrait au fond de ladite tranchée d'une ou plusieurs portion(s) superficielle(s) de ladite au moins une couche de matériau de grille dans le prolongement de ladite tranchée,
- formation dans lesdites une ou plusieurs couches de masquage dudit empilement :
   d'une ou plusieurs paires de blocs de masquage, chaque paire de bloc de masquage comportant un premier bloc de masquage et un deuxième bloc de masquage en regard du premier bloc de masquage, le premier bloc de masquage et le deuxième bloc de masquage étant disposés en regard l'un de l'autre et de part et d'autre de ladite tranchée, puis,
- gravure de ladite couche de matériau de grille de sorte à former un bloc de grille dans le prolongement de chaque bloc de masquage et à retirer, au fond de ladite tranchée, au moins une partie de ladite zone active située dans le prolongement desdites une ou plusieurs portion(s) superficielle(s) retirée(s) de ladite au moins une couche de matériau de grille.

Avec un tel procédé, on mutualise la gravure de la couche de matériau de grille qui se prolonge dans la zone active et l'on réalise un auto-alignement des blocs de grille par rapport aux régions restantes de la zone active, tout en limitant le nombre d'étapes nécessaires pour cela.

Selon une première possibilité de mise en oeuvre du procédé de fabrication, la tranchée de séparation est formée par gravure prolongée de sorte à effectuer ledit retrait d'une portion superficielle de ladite au moins une couche de matériau de grille. Avantageusement, le retrait au fond de la tranchée de ladite au moins une partie de ladite zone active est effectué de sorte à partager la zone active en une première région semi-conductrice et une deuxième région semi-conductrice entièrement disjointe de la première région semi-conductrice.

Selon une possibilité de mise en œuvre, la tranchée formée peut s'étendre au-delà de la zone active.

Selon une mise en oeuvre possible du procédé, après ledit retrait au fond de ladite tranchée desdites une ou plusieurs portion(s) superficielle(s), la formation des blocs de masquage peut comprendre des étapes de :
- formation d'un ou plusieurs éléments masquant transversaux par rapport à ladite tranchée, lesdits éléments masquant transversaux recouvrant ladite tranchée, lesdits éléments masquant étant formés par dépôt et structuration d'au moins une couche de masque dur, ladite couche de masque dur étant préservée dans ladite tranchée,
- gravure anisotrope de zones desdites une ou plusieurs couches de masquage non protégées par les éléments masquant transversaux,
- retrait desdits éléments masquant.

Selon une deuxième possibilité de mise en oeuvre du procédé de fabrication, la tranchée peut être réalisée par gravure desdites une ou plusieurs couches de masquage en s'arrêtant sur la couche de matériau de grille, le procédé comprenant en outre, après réalisation de la tranchée, la formation d'un ou plusieurs éléments masquant traversant ladite tranchée, lesdits éléments masquant étant transversaux par rapport à ladite tranchée et étant disjoints les uns des aux autres, le retrait desdites portions superficielles de ladite au moins une couche de matériau de grille dans le prolongement de ladite tranchée et la formation desdites une ou plusieurs paires de blocs de masquage étant réalisés par gravure anisotrope de zones non protégées par les éléments masquant, le procédé comprenant en outre, préalablement à ladite gravure de ladite couche de matériau de grille de sorte à former un bloc de grille : le retrait des éléments masquant. Dans ce cas, avantageusement, la tranchée peut s'étendre entièrement en regard de la zone active.

Selon une possibilité de mise en œuvre, la gravure anisotrope desdites zones non protégées par les éléments masquant transversaux peut être prolongée de sorte à partager la zone active en une première région semi-conductrice et une deuxième région semi-conductrice, la première région semi-conductrice et la deuxième région semi-conductrice étant reliées entre elles par des portions semi-conductrices. Avantageusement, après l'étape de formation des paires de blocs de grilles, le procédé peut comprendre en outre : la formation d'espaceurs isolants autour de chaque bloc de grille, une région des espaceurs s'étendant dans la tranchée.

Avantageusement, le procédé peut comprendre en outre après l'étape de formation des paires de blocs de grilles : une étape de croissance de matériau semi-conducteur dopé sur des régions de la zone active disposées de part et d'autre des blocs de grilles, de sorte à former des réservoirs de dopants.

Après la formation des réservoirs de dopants, le procédé peut comprendre la siliciuration d'une face supérieure desdits réservoirs de dopants et des blocs de grille.

Avantageusement, la zone active peut être formée d'un motif dans une couche superficielle d'un substrat de type semi-conducteur sur isolant muni d'une couche de support semi-conductrice et d'une couche isolante, ladite couche isolante, étant agencée entre la couche de support et ladite couche superficielle.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
Figure 1
Figure 2
Figure 3A
Figure 3B
Figure 4A
Figure 4B
Figure 5A
Figure 5B
Figure 6
Figure 7
Figure 8A
Figure 8B
Figure 9
Figure 10
Figure 11
Figure 12

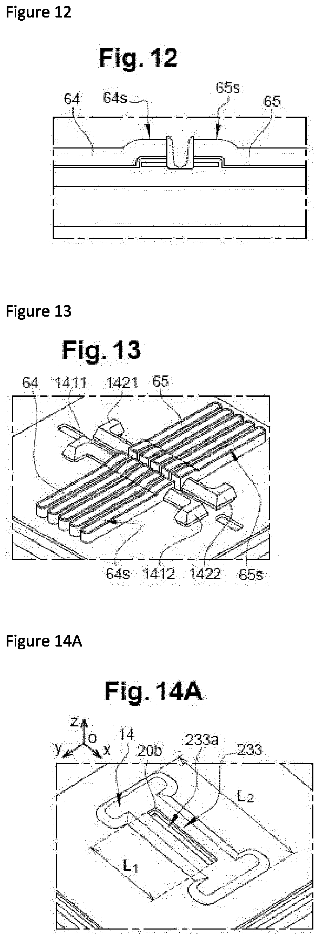

Figure 13 servent à illustrer un exemple de procédé de fabrication d'un dispositif quantique et suivant un premier mode de réalisation de l'invention.
Figure 14A
Figure 14B
Figure 15A
Figure 15B
Figure 16
Figure 17
Figure 18
Figure 19 servent à illustrer un exemple de procédé de fabrication d'un dispositif quantique et suivant un premier mode de réalisation de l'invention.
Figure 20 sert à illustrer une structure de dispositif quantique telle que mise en oeuvre suivant l'art antérieur.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation de la structure s'appliquent en considérant que la structure est orientée de la façon illustrée sur les figures.

### EXPOSÉ DÉTAILLÉ DE MODES DE RÉALISATION PARTICULIERS

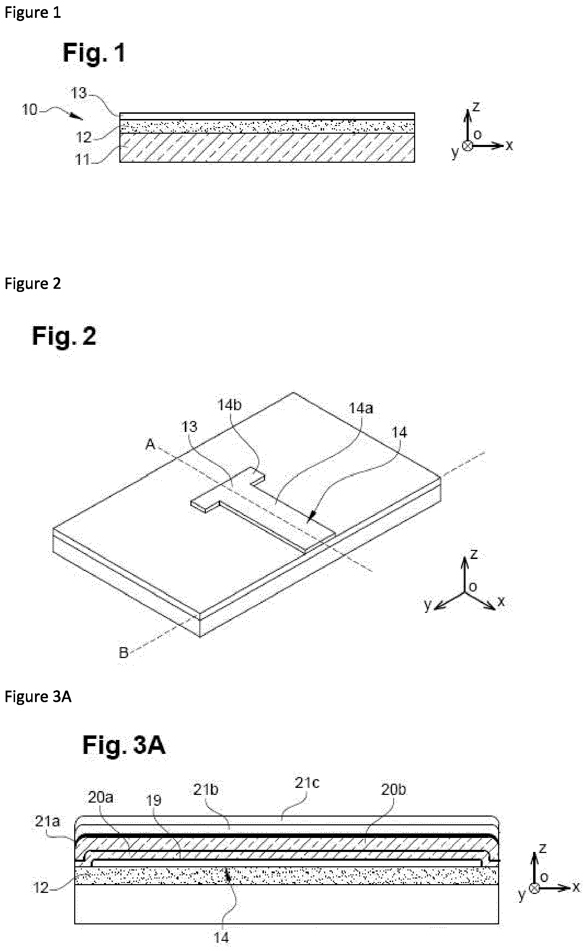

On se réfère tout d'abord à la figure 1 qui représente un matériau de départ possible pour la réalisation d'un dispositif quantique, en particulier à Qubits de spin, et qui se trouve sous forme d'un substrat 10 de type semi-conducteur sur isolant.

Le substrat comporte ainsi une couche support 11 en matériau semi-conducteur, une couche isolante enterrée 12 disposée sur la couche support 11 et une couche superficielle 13 semi-conductrice disposée sur la couche isolante 12.

Le substrat est typiquement un substrat SOI dont la couche superficielle 13 peut être en silicium, en particulier du ²⁸Si lorsque cette couche est amenée à accueillir des qubits de spin d'électrons. La couche isolante 12 et la couche de support 11 sont typiquement, respectivement, une couche en oxyde de silicium communément appelée de « BOX » (pour « Buried Oxide » ou « oxyde enterré ») et une couche à base de silicium. L'épaisseur de la couche superficielle 13, est par exemple comprise entre environ 5 nm et 50 nm, typiquement de l'ordre de 10 nm. L'épaisseur de la couche isolante enterrée 12 est par exemple comprise entre 15nm et 150nm. L'épaisseur de la couche support 11 (les épaisseurs étant des dimensions mesurées selon l'axe z du repère orthogonal [O ;x ;y ;z] donné sur la figure 1) peut être quant à elle par exemple de l'ordre de 775 µm dans le cas où l'on utilise une plaque (« wafer » selon la terminologie anglo-saxonne) de type 300 mm.

D'autres matériaux semi-conducteurs peuvent être envisagés pour la couche semi-conductrice superficielle 13. En particulier, lorsque cette couche superficielle 13 est amenée à accueillir des qubits de spin de trous, la couche superficielle peut être formée de Si₁₋ₓGeₓ avec x variant de préférence entre 0% à 70%.

Ensuite, on peut définir dans la couche superficielle 13 au moins un motif de zone active 14. La zone active 14 peut être formée d'une portion centrale 14a longiligne comportant, à ses extrémités, des portions 14b de largeur plus importante (une seule portion d'extrémité 14a étant représentée sur la vue en perspective partielle de la figure 2), mais d'autre formes peuvent être envisagées. Cette définition de la zone active 14 peut être réalisée par photolithographie et gravure de la couche superficielle 13, en particulier une gravure plasma avec arrêt sur la couche isolante 12.

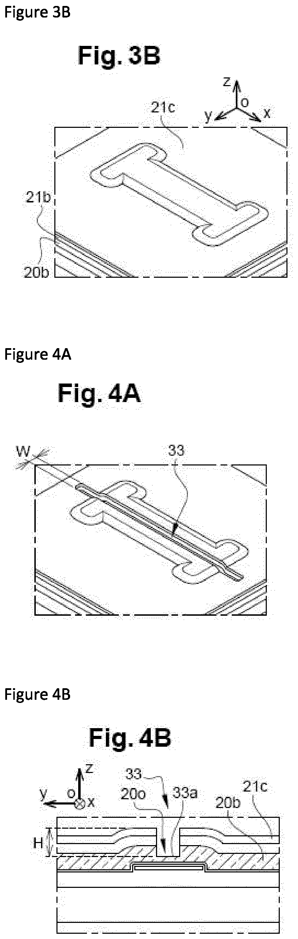

Puis, on réalise un empilement de grille recouvrant la zone active 14. Cet empilement est typiquement formé d'une couche de diélectrique 19 de grille et d'au moins une couche de matériau(x) de grille semi-conducteur(s) tel que du polysilicium dopé et/ou métallique(s) tel que du TiN, de l'Al, ou du W. Le diélectrique 19 de grille peut être un oxyde, en particulier un oxyde de silicium obtenu par dépôt ou par oxydation d'une épaisseur superficielle de la zone active 14. Par exemple, l'épaisseur de la couche de diélectrique 19 de grille peut être de l'ordre de 5 nm. Dans ce cas, selon un exemple de réalisation particulier, l'empilement de grille, peut, quant à lui, être formé d'une couche 20a métal de TiN d'épaisseur par exemple de l'ordre de 6 nm revêtue d'une couche 20b de polysilicium par exemple de l'ordre de 30 nm (la couche 20a étant représentée sur la figure 3A, mais pas sur les figures suivantes afin de rendre la lecture plus aisée). L'empilement de grille peut être revêtu (figures 3A, 3B donnant respectivement, une vue en coupe selon un plan de coupe passant par l'axe A et orthogonal à l'axe B donnés sur la figure 2 et, une vue en perspective) d'au moins une couche de masquage, en particulier d'une ou plusieurs couches 21b, 21c de masque dur formées typiquement de couches isolantes, par exemple en SiN et/ou SiO₂.

Dans l'exemple de réalisation illustré sur la figure 3A, un empilement est réalisé pour former ce masquage, avec une couche 21b, par exemple en SiN et d'épaisseur comprise par exemple entre 20 nm et 30 nm revêtue d'une couche 21c par exemple à base d'oxyde de silicium d'épaisseur comprise par exemple entre 20 nm et 30 nm. De manière optionnelle, une couche 21a d'oxyde peut être prévue sous la couche 21b en nitrure (une telle couche n'étant pas représentée sur les figures suivantes).

On forme ensuite une tranchée 33 à travers lesdites une ou plusieurs couches 21a, 21b, 21c de masquage. La tranchée 33 s'étend en regard de la zone active 14 et principalement dans le sens de la longueur de cette zone active 14 (dimension mesurée parallèlement à l'axe x du repère [O ; x ; y ; z]). Ainsi, la tranchée 33 s'étend au-dessus de la zone active 14 et principalement dans une première direction parallèle à l'axe x sur la figure 4A.

Dans l'exemple de réalisation particulier illustré sur la figure 4A, la tranchée 33 peut être prolongée en regard d'une région du substrat au-delà de la zone active 14 et dans laquelle la couche semi-conductrice superficielle a été retirée. La tranchée 33 est prévue avec une largeur W (dimension mesurée parallèlement à l'axe y du repère [O ; x ; y ; z], typiquement comprise entre 10 nm et 100 nm, par exemple de l'ordre de 40 nm.

La tranchée 33 comporte un fond 33a dévoilant le matériau de grille. Dans l'exemple de réalisation illustré sur la figure 4B, la tranchée 33 a pour particularité d'être prolongée, dans le sens de sa hauteur H (dimension mesurée parallèlement à l'axe z du repère [O ; x ; y ; z], la figure 4B donnant donnant une vue en coupe selon un plan de coupe passant par l'axe B et orthogonal à l'axe A indiqués sur la figure 2) dans une portion (espace référencé 200 sur la figure 4B cette portion ayant été retirée) de la couche 20b de matériau de grille. La réalisation de la tranchée 33 comporte ainsi, dans cet exemple de réalisation particulier, une gravure partielle d'une portion de matériau de grille et en particulier ici d'une portion supérieure de la couche 20b de polysilicium, une épaisseur du matériau de grille et en particulier de la couche 20b de polysilicium étant préservée à l'issue de la réalisation de la tranchée 33.

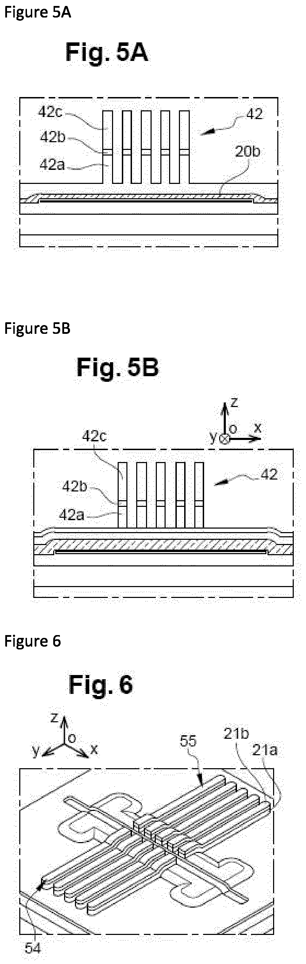

On forme ensuite un masque 42 (figure 5A donnant une vue en coupe selon un plan de coupe qui passe par la tranchée 33 et qui est parallèle à cette dernière, figure 5B donnant une vue en coupe selon un plan de coupe orthogonal à la tranchée 33).

Le masque 42 peut être formé de plusieurs couches empilées. Dans l'exemple de réalisation particulier illustré, le masque 42 comporte un tri-couches, avec une première couche 42a formant un masque dur organique par exemple une couche de carbone déposée par centrifugation (« spin-on-carbon » également appelée SOC), surmontée d'une deuxième couche 42b anti-reflet, par exemple une couche antireflet au silicium (SiARC), et d'une troisième couche 42c qui peut être à base de résine photosensible. Le masque 42 est formé typiquement en transférant un motif défini tout d'abord dans la troisième couche 42c dans les couches inférieures 42b et 42a. Dans un mode avantageux tel que représenté sur la figure 5A, la gravure est arrêtée au niveau de la première couche 42a, dès lors que la couche 21c supérieure du masquage est atteinte. On laisse ainsi un résidu de la première couche 42a au fond de la tranchée 33 préalablement formée masquant la couche 20b de matériau de grille. Cela permet par la suite de ne graver que les portions du masquage 21 révélées sans causer de sur-gravure dans la tranchée 33. Dans l'exemple de réalisation illustré, au niveau de la tranchée 33, la première couche 42a de masque dur recouvre entièrement la couche 20b de matériau de grille et protège cette dernière.

On définit ensuite par gravure à travers le masque 42 une ou plusieurs paires de blocs de masquage dans lesdites une ou plusieurs couches de masquage.

Une fois la gravure réalisée, le masque 42 est retiré. Par exemple, une gravure plasma à l'aide d'un plasma O₂ peut être employée pour retirer la couche de SOC. Les couches de résine et SiARC sont typiquement consommées lors d'une telle gravure.

Les blocs 54, 55 de masquage formés s'étendent typiquement dans une direction orthogonale à celle dans laquelle la zone active 14 s'étend principalement, autrement dit dans le sens de la largeur (dimension mesurée parallèlement à l'axe y du repère [O ; x ; y ; z]) de la zone active 14. Les blocs 54, 55 de masquage ont, dans cet exemple, une forme de barreau parallélépipédique. Les blocs 54, 55 de masquage formés s'étendent ainsi principalement dans une deuxième direction parallèle à l'axe y et orthogonale à ladite première direction dans laquelle la tranchée s'étend.

Plusieurs paires de blocs 54, 55 de masquage parallèles sont typiquement formées. Dans l'exemple de réalisation illustré sur la figure 6, chaque paire comporte un premier bloc 54 de masquage et un deuxième bloc 55 de masquage faisant face au premier bloc 54 de masquage, le premier bloc 54 de masquage et le deuxième bloc 55 de masquage sont disposés de part et d'autre de la tranchée 33, respectivement sur une première région de la zone active et sur une deuxième région de la zone active (la zone active étant recouverte et n'étant ici pas référencée sur la figure 6). Les blocs 54, 55 de masquage sont typiquement structurés par le biais d'une ou plusieurs gravures anisotropes par exemple à l'aide d'un plasma. La gravure des blocs de masquage, en particulier les couches SiO₂ et SiN, est typiquement réalisée par des procédés de gravure sèche plasma de type fluorocarbonné. Par exemple du CF₄ est utilisé pour graver la couche de SiO₂, et du CH₂F₂/SF₆ pour graver la couche de SiN.

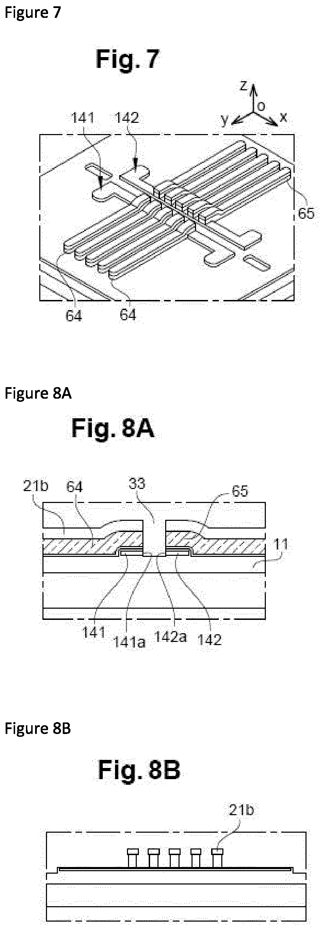

On effectue ensuite une gravure de l'empilement de grille, autrement dit de la ou les couches 20a, 20b de matériaux de grille et de la couche de diélectrique 19 de grille, de sorte à former sous chaque bloc 54, 55 de masquage ou dans le prolongement vertical de chaque bloc 54, 55 de masquage un bloc de grille. On réalise ainsi plusieurs paires de blocs 64, 65 de grille. Les blocs 64, 65 de grille sont typiquement formés par gravure anisotrope par exemple à l'aide d'un plasma. Au niveau de la tranchée 33, la gravure conduit au retrait du ou des matériaux de grille et du diélectrique de grille. Du fait qu'une gravure partielle dans la couche 20b de matériau de grille réalisée précédemment en lien avec la figure 4B a été faite, la gravure peut être prolongée plus aisément à travers la zone active 14 de sorte à atteindre la couche isolante 12. Chaque paire de blocs 64, 65 comporte un premier bloc 64 de grille et un deuxième bloc 65 de grille faisant face au premier bloc 64 de grille, le premier bloc 64 de grille et le deuxième bloc 65 de grille étant disposés de part et d'autre de la tranchée 33, respectivement sur une première région 141 de la zone active et sur une deuxième région 142 de la zone active disjointe et séparée de la première région (figure 7) par un espace au fond de la tranchée 33. Les blocs 64, 65 de grille ont, dans cet exemple, une forme de barreau parallélépipédique. Ces barreaux s'étendent typiquement dans une direction orthogonale à celle dans laquelle les régions 141, 142 séparées de la zone active 14 s'étendent principalement, autrement dit dans le sens de leur largeur (dimension mesurée parallèlement à l'axe y du repère [O ; x ; y ; z]). Les paires de blocs 64, 65 de grille sont de préférence régulièrement espacées avec une répartition dense, par exemple telle que le pas de répartition d'une paire de blocs de grille est de l'ordre de 100 nm. Les blocs 64, 65 de grille s'étendent ici principalement dans la deuxième direction orthogonale à ladite première direction ou direction principale de la tranchée 33.

La première région 141 peut être celle dans laquelle des boites quantiques sont destinées à être formées tandis que la seconde région 142 peut être amenée à former des détecteurs de charge.

Le fait d'avoir réalisé la tranchée 33 avant l'étape de définition des blocs 64, 65 de grille participe à pouvoir disposer précisément ces derniers par rapport à la zone active 14 et en particulier par rapport à des bords 141a, 142a, des régions 141, 142 distinctes formées à partir de cette zone active 14. Le fait d'avoir réalisé précédemment un retrait partiel de matériau de grille 20b dans la tranchée 33, conduit après formation des blocs de masquage 54,55, à avoir deux hauteurs distinctes de matériau 20 de grille à graver. La gravure réalisée ici permet de consommer, hors de la tranchée 33, des zones plus épaisses de matériau 20b de grille et de s'arrêter sur la zone active 14, tandis que dans la tranchée 33 on consomme des zones moins épaisses de matériau 20b de grille et on étend la gravure jusque dans la zone active 14, afin de réaliser la séparation de cette dernière. La gravure de la zone active 14 et séparation en deux régions 141, 142 se fait ainsi de manière auto-alignée avec les blocs 64, 65 de grille. Une partie de ladite zone active située dans le prolongement et en regard de la portion superficielle 200 retirée précédemment est à son tour retirée. Par située dans le prolongement, on entend ici un en particulier un prolongement vertical autrement dit une zone située dans une projection verticale. Les deux régions 141, 142 séparées sont distinctes et espacées de sorte que l'on empêche ici un passage de charges par effet tunnel dans une zone entre et séparant ces régions 141, 142.

Autrement dit, le partage de la zone active 14 en une première région semi-conductrice 141 et une deuxième région semi-conductrice 142 permet de supprimer le couplage tunnel entre ces deux régions 141, 142.

Dans l'exemple de réalisation illustré sur la figure 8A, 8B, les paires de blocs 64, 65 de grille réalisées sont encore recouvertes de la couche inférieure 21b de masquage par exemple en SiN, la couche supérieure 21c de masquage ayant été retirée lors de la gravure des couches 20a,b de matériau de grille au travers des blocs de masquage 54,55.

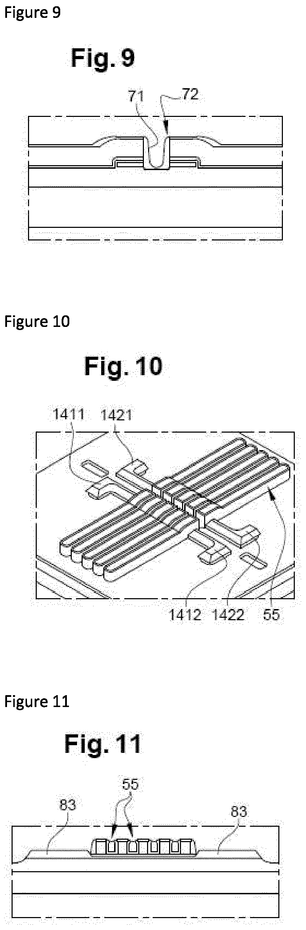

Des espaceurs isolants 72 peuvent être ensuite formés autour de chacun des blocs 64, 65 de grille. Les espaceurs 72 peuvent être réalisés par dépôt d'au moins un matériau 71 isolant. Le dépôt est effectué de sorte à combler des espaces inter-grilles, en particulier entre chaque paire de grilles (figure 9) et entre des grilles adjacentes (figure 10) de paires de grilles distinctes. Le(s) matériau(x) isolant 71 des espaceurs 72 est typiquement choisi parmi l'un ou plusieurs des matériaux suivants : SiN, SiO₂, SiCO, SiBCN, SiOCN. Le procédé de dépôt peut être conforme, et en particulier de type ALD (pour « Atomic Layer Déposition » ou « dépôt de couche atomique ») afin de remplir les espaces sans création de défaut de remplissage. Selon un exemple de réalisation particulier, le matériau isolant 71 déposé a une épaisseur de l'ordre de 30 nm.

Dans l'exemple de réalisation illustré sur la figure 10, on effectue ensuite un retrait partiel par gravure de ce matériau isolant 71 de sorte à le retirer de portions d'extrémités 1411, 1412, et 1421, 1422 respectivement de la première région 141, et de la deuxième région 142 de la zone active 14.

Pour compléter la formation de réservoirs de dopants sur ces portions 1411, 1412, et 1421, 1422 et augmenter leur épaisseur on peut ensuite faire croitre une ou plusieurs couches de matériau(x) semi-conducteur(s) 83 sur ces portions 1411, 1412, et 1421, 1422 dévoilées de la zone active (figure 11). On peut effectuer cela par croissance épitaxiale de silicium ou par le biais d'un dépôt CVD (pour « chemical vapor déposition », i.e. dépôt chimique en phase vapeur) par exemple de Germanium. Un dopage peut être alors réalisé par implantation ionique ou bien par dopage *in situ* effectué concomitamment à la croissance de la ou les couches de matériau(x) semi-conducteur(s) 83 par exemple pour former du Si:P (silicium dopé au phosphore) ou du SiGe:B (Silicium Germanium dopé au Bore).

Afin de diminuer la résistance de contact des réservoirs à dopants et/ou des blocs 64, 65 de grille lorsqu'au moins une partie de ces blocs est réalisée en matériau semi-conducteur dopé, on peut ensuite former des zones à base de matériau métallique sur ces réservoirs et/ou blocs de grille. Pour cela, on retire le restant des blocs de masquage (figures 12 et 13) agencés sur les blocs 64, 65 de grille de manière à dévoiler la face supérieure 64s, 65s de ces derniers. Un tel retrait peut être réalisé au moyen d'un procédé de gravure chimique sélective. Par exemple, une gravure à l'aide de H₃PO₄ à une température de l'ordre de 100°C et pendant une durée d'une heure peut être mise en œuvre lorsqu'on souhaite retirer la couche 21b de masquage en SiN. La durée de gravure peut être de l'ordre de 30 min, pour une couche de SiN de l'ordre de 20 nm déposée par PECVD.

On peut ensuite former des zones d'alliage de métal et de semi-conducteur. On forme de telles zones respectivement sur une face supérieure 64s, 65s des blocs 64, 65 de grille ainsi que sur une face supérieure des réservoirs 1411, 1412, 1421, 1422 à dopants. Pour cela, un procédé de siliciuration comprenant une étape de dépôt d'au moins une couche de métal, tel que par exemple du Ni, du Pt, du W, du Co, du Ti, ou du V peut être effectué. La couche de métal peut être éventuellement recouverte d'une couche d'encapsulation qui peut être métallique. Un exemple d'encapsulation est formé par dépôt de TiN, d'épaisseur par exemple de l'ordre de 10 nm. Un traitement thermique est effectué pour réaliser la siliciuration. Un tel traitement peut être mis en oeuvre à une température comprise entre 200°C et 900°C et une durée adaptée en fonction de la température de traitement. Un retrait du métal n'ayant pas réagi peut être ensuite effectué par exemple par gravure humide en utilisant une solution de type SPM (pour « Sulfuric Peroxide Mix » autrement dit mélange de péroxyde sulfurique) à chaud. Un deuxième recuit de siliciuration peut être également effectué.

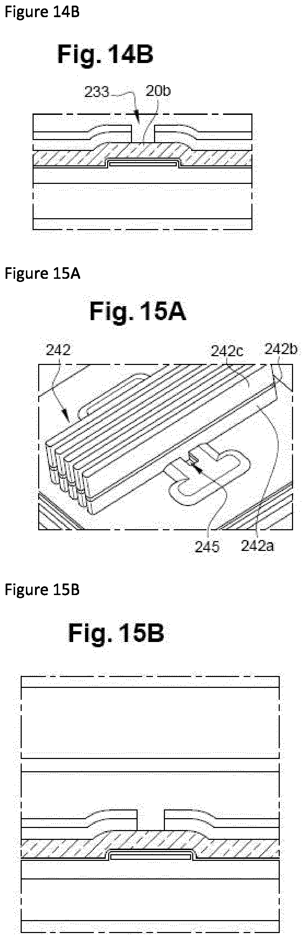

Une variante de procédé de réalisation de dispositif quantique va à présent être décrite en liaison avec les figures 14 à 19.

On peut suivre tout d'abord une séquence d'étapes telle que décrite précédemment en lien avec les figures 1 à 4, afin de définir une zone active, un empilement de grille recouvrant notamment cette zone active et des couches de masquage sur cet empilement.

Puis (figure 14A), on forme une tranchée 233 à travers une ou plusieurs couches de masquage, cette tranchée s'étendant cette fois entièrement en regard de la zone active 14 et ne dépasse pas cette zone 14. Une telle tranchée 233 est réalisée typiquement par gravure anisotrope en particulier à l'aide d'un plasma. Par exemple, une gravure sèche plasma peut être employée pour graver les couches SiO₂ et SiN typiquement à l'aide d'un composé fluoro-carboné. Par exemple du CF₄ est utilisé pour graver le SiO2, tandis que du CH₂F₂/SF₆ peut être employé pour graver la couche de SiN.

La tranchée 233 s'étend ainsi selon une longueur L₂ supérieure à une longueur L₁ (dimensions mesurées parallèlement à l'axe x du repère [O ; x ; y ; z]) de la zone active 14. La tranchée 233 ainsi formée comporte un fond 233a dévoilant une couche 20b de matériau de grille. Dans cet exemple de réalisation (et contrairement au procédé décrit précédemment en lien avec la figure 4B où la tranchée était prolongée dans la couche 20b de matériau de grille) on forme ici la tranchée 233 en s'arrêtant au niveau de la surface de matériau de grille de préférence sans graver ce dernier (figure 14B).

On réalise ensuite (figure 15A et 15B) un masque formé de plusieurs éléments masquant 242 distincts, ici de forme oblongue et qui peuvent être en particulier parallélépipédiques. Chaque élément masquant 242 peut, là encore, être formé par exemple d'un masque dur 242a organique par exemple de type SOC, surmontée d'une couche 242b anti-reflet, par exemple de type SiARC, et d'une couche 242c de résine photosensible.

Les éléments masquant 242 sont transversaux par rapport à la tranchée 233. Ces éléments masquant 242 sont ainsi typiquement parallèles entre eux et orientés orthogonalement à la tranchée 233. Dans cet exemple, les éléments masquant 242 ont pour particularité d'être disjoints les uns des autres, de sorte qu'au fond de la tranchée 233, des zones 245 de la couche 20b de matériau de grille sont dévoilées et ne sont ainsi pas protégées.

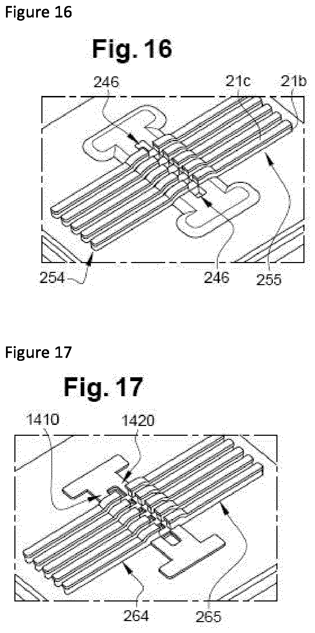

Puis, une gravure anisotrope de parties des couches de masquage 21b, 21c non protégées par les éléments masquant 242 transversaux est effectuée. On forme ainsi, les blocs 254, 255 de masquage (figure 16). Lors de cette gravure anisotrope les portions 245 dévoilées de matériau de grille, et non recouvertes pas les éléments masquant 242, sont partiellement gravées au fond de la tranchée 233, de manière à former des trous 246 dans la couche de matériau de grille.

On effectue ensuite un retrait des éléments masquant. Puis, une gravure anisotrope de la ou les couches de matériau de grille est effectuée de sorte à former des blocs 264, 265 de grille reproduisant les motifs des blocs 254, 255 de masquage (figure 17). Une telle gravure est typiquement mise en oeuvre à l'aide d'un plasma. Par exemple, un procédé de gravure anisotrope plasma à l'aide de HBr peut être utilisé pour graver du polysilicium, tandis qu'une gravure SiCl₂/Cl₄ est employée pour graver du TiN.

La gravure partielle de la couche 20b de matériau de grille préalablement réalisée est alors prolongée de sorte à partager la zone active 14 en une première région semi-conductrice 1410 et une deuxième région semi-conductrice 1420. Les trous 246 formés précédemment dans la couche 20b de matériau de grille sont ici reproduits dans la zone active 14. On retire ainsi au fond de la tranchée 233 des parties de ladite zone active 14 situées dans le prolongement des portions 246 de la couche de matériau de grille qui n'ont pas été protégées par les éléments masquant 242.

On forme ainsi, comme illustré sur la figure 18, des trous 1417 entre la première région semi-conductrice 140 et la deuxième région semi-conductrice 1420, la première région semi-conductrice 1410 et la deuxième région semi-conductrice 1420 étant reliées entre elles par des portions semi-conductrices 1415 issues de la zone active 14 et agencées entre ces trous 1415.

Comme dans l'exemple de procédé précédemment décrit, on peut ensuite former des espaceurs isolants 272 autour des blocs 264, 265 de grille (figure 19). D'autres étapes telles que la formation de réservoirs de dopants puis la siliciuration des réservoirs et de portion dévoilées de blocs de grille peuvent être également réalisées, par exemple d'une manière telle que décrite précédemment en lien avec le premier mode de réalisation.

La structure ici formée dans ce deuxième mode de réalisation permet d'obtenir un couplage direct par effet tunnel entre les boites quantiques formées dans la première région semi-conductrice et les boites quantiques utilisées pour la détection formée dans la seconde région semi-conductrice. Cela permet d'envisager la mise en place de protocoles de lecture de spin en parallèle par réflectométrie de grille. Elle peut ainsi permettre de réaliser un mode de détection distinct de celui de la structure dont la réalisation a été décrite précédemment en lien avec les figures 1 à 13.

Une première rangée de boites quantiques peut alors être utilisée pour stocker/manipuler l'information quantique alors qu'une deuxième rangée de boites quantiques peut être utilisée pour la détection de charge et de spin.

Pour cette structure comme pour la précédente, le nombre de blocs de grille n'est pas limité à celui illustré. La structure dont la fabrication a été décrite en lien avec les figures 15-19 peut comporter une matrice de 2xN boites quantiques alignées (avec N ≥1).

## Revendications

1. Procédé de fabrication d'un dispositif quantique, comprenant des étapes de :
- formation sur une zone (14) semi-conductrice dite « zone active » reposant sur un substrat (10) : d'un empilement comprenant au moins une couche (20a, 20b) de matériau de grille et une ou plusieurs couches (21b, 21c) de masquage sur cette couche (20a, 20b) de matériau de grille, puis
- formation, au-dessus de la zone active (14) : d'une tranchée (33, 233) de séparation par gravure à travers lesdites une ou plusieurs couches (21b, 21c) de masquage (33, 233), la tranchée s'étendant principalement dans une première direction,
- retrait au fond de ladite tranchée (33, 233) d'une ou plusieurs portion(s) superficielle(s) (200a) de ladite au moins une couche (20a, 20b) de matériau de grille (20b) dans le prolongement vertical de ladite tranchée (33, 233),
- formation dans lesdites une ou plusieurs couches de masquage (21b, 21c) dudit empilement : d'une ou plusieurs paires de blocs (54, 55) de masquage, chaque paire de bloc de masquage comportant un premier bloc (54) de masquage et un deuxième bloc (55) de masquage en regard du premier bloc de masquage, le premier bloc de masquage et le deuxième bloc de masquage étant disposés en regard l'un de l'autre et de part et d'autre de ladite tranchée (33, 233), le premier bloc de masquage et le deuxième bloc de masquage s'étendant principalement dans une deuxième direction orthogonale à la première direction, puis,
- gravure de ladite couche de matériau de grille de sorte à former un bloc (64, 65, 264, 265) de grille dans le prolongement vertical de chaque bloc de masquage et retirer, au fond de ladite tranchée (33, 233), au moins une partie de ladite zone active (14) située dans le prolongement vertical desdites une ou plusieurs portion(s) superficielle(s) (200) retirée(s) de ladite au moins une couche (20a, 20b) de matériau de grille, les blocs de grille s'étendant principalement dans la deuxième direction.

2. Procédé de fabrication selon la revendication 1, dans lequel la tranchée (33) de séparation est formée par gravure prolongée de sorte à effectuer ledit retrait d'une portion superficielle (200) de ladite au moins une couche (20a, 20b) de matériau de grille (20b).

3. Procédé de fabrication selon la revendication 2, dans lequel le retrait au fond de la tranchée (33) de ladite au moins une partie de ladite zone active (14) est effectué de sorte à partager la zone active (14) en une première région semi-conductrice (141) et une deuxième région semi-conductrice (142) entièrement disjointe de la première région semi-conductrice (141).

4. Procédé de fabrication selon l'une des revendications 1 à 3, dans lequel la tranchée (33) formée s'étend au-delà de la zone active (14).

5. Procédé de fabrication selon l'une des revendications 1 à 4, dans lequel après ledit retrait au fond de ladite tranchée (33) desdites une ou plusieurs portion(s) superficielle(s), la formation des blocs (54, 55) de masquage comprend des étapes de :
- formation d'un ou plusieurs éléments masquant (42) transversaux par rapport à ladite tranchée (33), lesdits éléments masquant (42) transversaux recouvrant ladite tranchée, lesdits éléments masquant étant formés par dépôt et structuration d'au moins une couche (42a) de masque dur, ladite couche (42a) de masque dur étant préservée dans ladite tranchée (33),
- gravure anisotrope de zones desdites une ou plusieurs couches (21b, 21c) de masquage non protégées par les éléments masquant (42) transversaux,
- retrait desdits éléments masquant (42).

6. Procédé de fabrication selon la revendication 1, dans lequel la tranchée (233) est réalisée par gravure desdites une ou plusieurs couches de masquage (21b, 21c) en s'arrêtant sur la couche (20b) de matériau de grille, le procédé comprenant en outre, après réalisation de la tranchée (233), la formation d'un ou plusieurs éléments masquant (242) traversant ladite tranchée (233), lesdits éléments masquant (242) étant transversaux par rapport à ladite tranchée (233) et étant disjoints les uns des aux autres, le retrait desdites portions superficielles (245) de ladite au moins une couche (20a, 20b) de matériau de grille dans le prolongement de ladite tranchée et la formation desdites une ou plusieurs paires de blocs (54, 55) de masquage étant réalisés par gravure anisotrope de zones non protégées par les éléments masquant (242), le procédé comprenant en outre, préalablement à ladite gravure de ladite couche de matériau de grille de sorte à former un bloc (264, 265) de grille : le retrait des éléments masquant (242).

7. Procédé de fabrication selon la revendication 6, dans lequel la tranchée (233) s'étend entièrement en regard de la zone active (14).

8. Procédé de fabrication selon l'une des revendications 6 ou 7, la gravure anisotrope desdites zones non protégées par les éléments masquant (242) transversaux étant prolongée de sorte à partager la zone active (14) en une première région semi-conductrice (1410) et une deuxième région semi-conductrice (1420), la première région semi-conductrice et la deuxième région semi-conductrice étant reliées entre elles par des portions (1415) semi-conductrices.

9. Procédé selon l'une des revendications 1 à 8, comprenant en outre, après l'étape de formation des paires de blocs de grilles : la formation d'espaceurs isolants autour de chaque bloc de grille, une région des espaceurs s'étendant dans la tranchée.

10. Procédé selon l'une des revendications 1 à 9, comprenant en outre après l'étape de formation des paires de blocs de grilles,
- croissance de matériau semi-conducteur (83) dopé sur des régions de la zone active (14) disposées de part et d'autre des blocs de grilles, de sorte à former des réservoirs de dopants.

11. Procédé selon la revendication 10, comprenant en outre après la formation des réservoirs de dopants, la siliciuration d'une face supérieure desdits réservoirs de dopants et des blocs de grille.

12. Procédé selon l'une des revendications 1 à 11, dans lequel la zone active (14) est formée d'un motif dans une couche superficielle (13) d'un substrat de type semi-conducteur sur isolant muni d'une couche (11) de support semi-conductrice et d'une couche isolante (12), ladite couche isolante (12), étant agencée entre la couche de support (11) et ladite couche superficielle (13).

13. Procédé de fabrication selon l'une des revendications 1 à 12, dans lequel le retrait au fond de la tranchée (33) de ladite au moins une partie de ladite zone active (14) est effectué de sorte à graver la zone active sur toute son épaisseur.
